# EUROPEAN PATENT APPLICATION

(11) **EP 3 514 443 A1**
(43) Date of publication of application: **24.07.2019**
(21) Application number: 17850800.8
(22) Date of filing: 07.09.2017
(51) Int. Cl.: F21S 41/00

(54) **LIGHT EMITTING MODULE AND LAMP UNIT**

(30) Priority: 15.09.2016 JP 2016180831
(71) Applicant: Koito Manufacturing Co., Ltd., Tokyo 108-8711 (JP)
(72) Inventor: TOKIDA, Tsukasa, Shizuoka-shi Shizuoka 424-8764 (JP); SUZUKI, Tetsuya, Shizuoka-shi Shizuoka 424-8764 (JP); OHNO, Tomoyuki, Shizuoka-shi Shizuoka 424-8764 (JP)
(74) Representative: Algemeen Octrooi- en Merkenbureau B.V.
(86) International application number: PCT/JP2017/032342
(87) International publication number: WO 2018/051897

(57) **Abstract**

A light emitting module 24 is a light emitting module used in a lamp and includes: a light source in which a plurality of semiconductor light emitting elements 36 are provided as a light emitting element array of a plurality of stages; and a mount 52 in which the light source is mounted. In the mount 52, a plurality of standard packages 34 of the same configuration are arranged, and the standard package 34 has the plurality of semiconductor light emitting elements 36 carried thereon.

## Description

### [TECHNICAL FIELD]

The present invention relates to a light emitting module and a lamp unit provided with the light emitting module.

### [BACKGROUND ART]

There is known a vehicle lamp provided with a light source in which a plurality of semiconductor light emitting elements are arranged as a light emitting element array of a plurality of stages (see patent document 1). Such a vehicle lamp is capable of forming a plurality of light emission patterns by turning the respective semiconductor light emitting elements on and off.

[patent document No. 1] JP2013-168434

### [PROBLEM TO BE SOLVED BY THE INVENTION]

It should be noted that different light emission characteristics required of the light source or different types of vehicle lamps provided with the light source often cannot be addressed by the completely identical configuration and layout of the light emitting element array. For example, the light emitting element array in the lamp unit disclosed in patent document 1 is realized by using a dedicated device-carrying substrate carrying a row of 16 LEDs and a dedicated device-carrying substrate carrying a row of eight LEDs. It is also possible to carry a light emitting element array including 24 LEDs on a single substrate, but such a substrate should equally be poorly versatile. Thus, it is common to specially design the configuration of a mount for carrying the entirety of the light emitting element array.

However, a mount designed as a dedicated component is poorly versatile as it is difficult to use it in other products and so tends to increase the cost.

The present invention addresses such an issue and a purpose thereof is to realize at least a part of various light emitting element arrays of different configurations by means of a standard component.

### [MEANS TO SOLVE THE PROBLEM]

A light emitting module according to an embodiment of the present invention is used in a lamp and includes: a light source in which a plurality of light emitting elements are provided as a light emitting element array of a plurality of stages; and a mount in which the light source is mounted. In the mount, a plurality of standard packages of the same configuration are arranged, and the standard package carries a plurality of light emitting elements.

According to this embodiment, at least a portion of the light emitting element array of a plurality of stages can be formed by a standard package carrying a plurality of light emitting elements.

The standard package may include: a first standard package that forms a first row in the light emitting element array, and a second standard package that forms a second row in the light emitting element array different from the first row. In this way, the standard packages are used in a plurality of rows in the light emitting element array. The increase in the number of standard packages employed enables reduction in the cost and improvement in the work efficiency.

The standard package may include a rectangular sub-mount, a plurality of electrodes may be provided along one longer side of the sub-mount, and the electrodes may be used to feed power to the light emitting elements. The one-sided arrangement of the electrodes of the standard package simplifies the layout of the wiring for feeding power as compared with the case where the electrodes are on both sides.

The plurality of light emitting elements may be provided between the other longer side of the sub-mount and the plurality of electrodes. This makes it possible to reduce the distance between the plurality of light emitting elements and the light emitting elements mounted in an adjacent further sub-mount.

The plurality of standard packages may be provided in the mount such that the electrodes are provided at an outer edge of the light emitting element array. This increases the flexibility of the layout for wiring the electrodes and also simplifies the layout.

Another embodiment of the present invention relates to a lamp unit used in a vehicle headlamp. The lamp unit may include; the aforementioned light emitting module; and an optical member that projects light emitted by the light source of the light emitting module forward as a light distribution pattern. The plurality of standard packages may be provided in the mount such that the number N1 of standard packages carrying light emitting elements for radiating a lower part of the light distribution pattern is larger than the number N2 of standard packages carrying light emitting elements for radiating an upper part of the light distribution pattern.

According to this embodiment, a vertically asymmetrical light distribution pattern is realized by using the standard packages.

The lamp unit may include: a lower light emitting part formed by a standard package carrying the light emitting element for radiating a lower part of the light distribution pattern; and an upper light emitting part formed by a standard package carrying the light emitting element for radiating an upper part of the light distribution pattern. Defining a position at which a straight line passing through an optical center or a dimensional center of the optical member intersects the mount as a reference point, a first offset by which a center of the upper light emitting part is shifted from the reference point in a direction of vehicle width may be larger than a second offset by which a center of the lower light emitting part is shifted from the reference point in a direction of vehicle width.

Accordingly, in the vehicle headlamp in which a pair of left and right lamp units in a mirror arrangement are used, the illuminated range illuminated by the combined light distribution pattern, produced by the upper light emitting parts of the respective lamp units each formed by a relatively small number of standard packages, can be extended.

Optional combinations of the aforementioned constituting elements, and implementations of the invention in the form of methods, apparatuses, and systems may also be practiced as additional modes of the present invention.

### [ADVANTAGE OF THE INVENTION]

According to the present invention, at least a portion of various light emitting element arrays having different configurations can be realized by a standard component.

### [BRIEF DESCRIPTION OF THE DRAWINGS]

Fig. 1 is a schematic horizontal cross-sectional view of a vehicle headlamp using the lamp unit according to the embodiment;
Fig. 2A is a top view showing an exemplary standard package according to the embodiment; Fig. 2B is an A-A cross-sectional view of the standard package shown in Fig. 2A; and Fig. 2C is a circuit diagram of the standard package shown in Fig. 2A;
Fig. 3 is a front view of a light emitting module according to the embodiment;
Fig. 4 is a B-B cross-sectional view of the light emitting module shown in Fig. 3;
Fig. 5A is front view showing an exemplary light emitting module according to another embodiment; Fig. 5B is a side schematic view of the lamp unit provided with the light emitting module shown in Fig. 5A, and Fig. 5C shows a light distribution pattern formed by the lamp shown in Fig. 5B;
Fig. 6A is a front view showing a variation of the light emitting module applied to the right lamp according to the other embodiment, and Fig. 6B shows a light distribution pattern formed by the lamp provided with the light emitting module shown in Fig. 6A;
Fig. 7A is a front view showing a variation of the light emitting module applied to the left lamp according to the other embodiment, and Fig. 7B shows a light distribution pattern formed by the lamp provided with the light emitting module shown in Fig. 7A;
Fig. 8A shows illumination distribution occurring when the light emitting module shown in Fig. 5a is used in the right lamp and the left lamp, and Fig. 8B shows illumination distribution occurring when the the light emitting module shown in Fig. 6A is used in the right lamp and the light emitting module shown in Fig. 7A is used in the left lamp; and
Fig. 9 is a front view of a light emitting module according to a variation of the embodiment.

### [MODE FOR CARRYING OUT THE INVENTION]

A detailed description will be given of embodiments of the present invention with reference to the drawings. In the explanations of the figures, the same elements shall be denoted by the same reference numerals, and duplicative explanations will be omitted appropriately.

### (Vehicle headlamp)

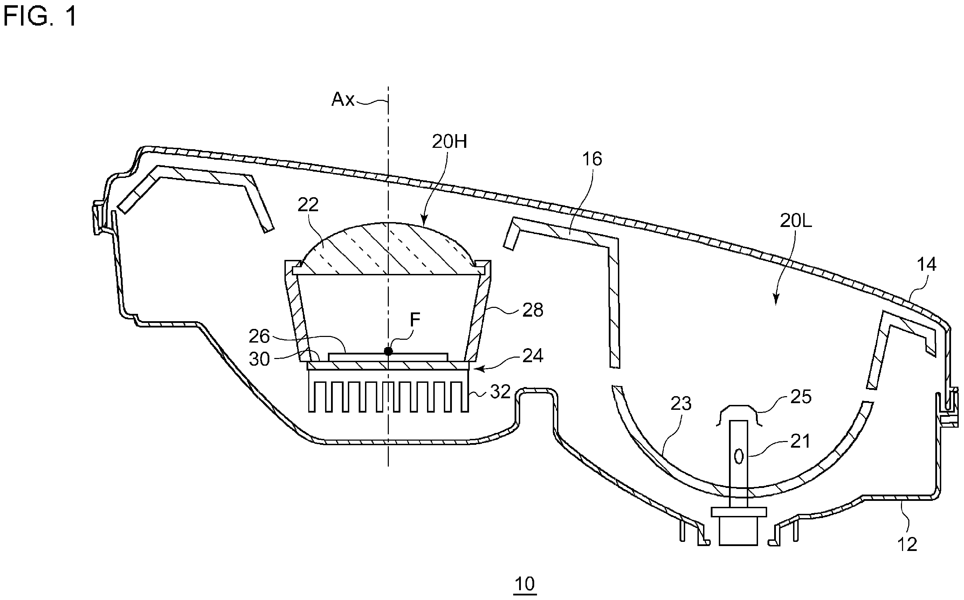

Fig. 1 is a schematic horizontal cross-sectional view of a vehicle headlamp 10 using the lamp unit according to the embodiment.

The vehicle headlamp 10 according to the embodiment is configured such that a low beam lamp unit 20L and a high beam lamp unit 20H are accommodated in a lamp chamber formed by a lamp body 12 and a translucent cover 14 mounted to the front opening of the lamp body 12. The low beam lamp unit 20L and the high beam lamp unit 20H are mounted to the lamp body 12 by a support member (not shown). An extension member 16 having openings where the lamp units are located is fixed to the lamp body 12 or the translucent cover 14, and region between the front opening of the lamp body 12 and the respective lamp units is screened from a space in front.

The low beam lamp unit 20L is a lamp unit of reflective type well known in the related art and includes a light source bulb 21 and a reflector 23. The low beam lamp unit 20L causes the reflector 23 to reflect light emitted from the light source bulb 21. A light shielding plate (not shown) cuts a portion of light traveling forward from the reflector 23 so as to form a low beam light distribution pattern having a predetermined cutoff line. A shade 25 for cutting the light emitted forward directly from the light source bulb 21 is provided at the end of the light source bulb 21. The shape of the low beam lamp unit 20L is not limited to the one described above. The low beam lamp unit 20L may be a lamp unit of projector type like the high beam lamp unit 20H described later.

The high beam lamp unit 20H is a lamp unit of projector type and includes a projection lens 22, a light emitting module 24 provided with a light emitting diode (LED) array 26 including an array of a plurality of LEDs, and a holder 28 for supporting the projection lens 22 and the light emitting module 24. The projection lens 22 is a plano-convex aspherical lens, the front surface thereof being convex and the rear surface thereof being planar and is located on a light axis Ax extending in the longitudinal direction of the vehicle. The projection lens 22 is configured to project an image on the back focal plane, including the back focal point F, onto a vertical virtual screen located in front of the lamp as an inverted image. The peripheral portion of the projection lens 22 is supported by the front annular groove of the holder 28.

The light emitting module 24 is fixed at the rear end of the holder 28 such that the LED array 26 is provided near and behind the back focal point F of the projection lens 22. The holder 28 is mounted to the lamp body 12 by a support member (not shown).

The light emitting module 24 includes the LED array 26, a circuit substrate 30 for carrying the LED array 26, and a heat dissipation plate 32 for dissipating the heat generated by the LED array 26. The LED array 26 is fixed on the front surface of the circuit substrate 30 such that the light emission surfaces faces forward in the direction of the light axis Ax. The center of the LED array 26 is located on the light axis Ax. The heat dissipation plate 32 is fixed to the back surface of the circuit substrate 30.

### (Standard package)

The LED array may be comprised of any of a variety of combinations of the number of LEDs and the number of stages. That makes it necessary to provide a mount and a circuit substrate suited to the configuration of the LED, which reduces the versatility and leaves room for improvement in the reduction of component cost. According to the embodiment, one or a plurality of types of standard packages, in which one or a plurality of LEDs are carried, are used to implement the LED array.

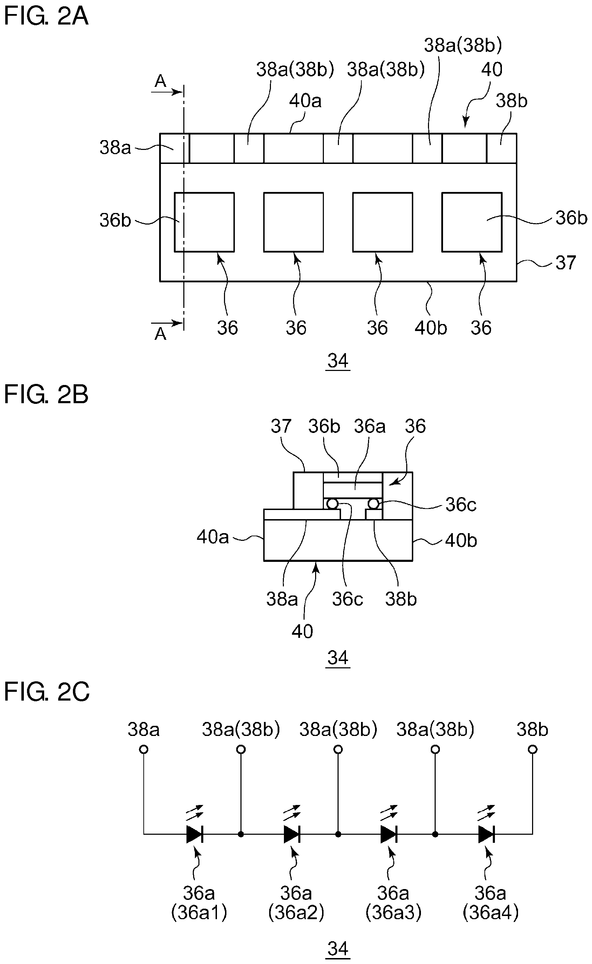

Fig. 2A is a top view showing an exemplary standard package according to the embodiment; Fig. 2B is an A-A cross-sectional view of the standard package shown in Fig. 2A; and Fig. 2C is a circuit diagram of the standard package shown in Fig. 2A. In the standard package shown in Fig. 2A, four LEDs as semiconductor light emitting elements are carried. For example, one, two, three, five, six, seven, or eight LEDs may be carried, or a larger number of LEDs may be carried.

As shown in Fig. 2A, the standard package 34 includes four semiconductor light emitting elements 36. For example, an LED device, a laser diode (LD) device, or an electro-luminescence (EL) device may be suitably used as the semiconductor light emitting element 36. The standard package 34 according to the embodiment is configured as an arrangement of four LED chips 36a in a line.

A plate-shaped fluorescent layer 36b is formed on the rectangular light emission surface of the LED chip 36a. For example, the LED chip 36a is an LED of InGaN type that emits blue light having a light emission peak wavelength in a range 450∼480 nm. Further, the fluorescent layer 36b is a light wavelength conversion member excited by blue light and emitting yellow light. For example, a YAG phosphor is used. For example, the fluorescent layer 36b may be manufactured by processing a ceramic phosphor into a plate shape. The fluorescent layer 36b may be manufactured by dispersing fluorescent powder in a transparent resin.

The semiconductor light emitting element 36 emits white light as a result of the blue light emitted by the LED chip 36a and the yellow light emitted by the fluorescent layer 36b being mixed.

The plurality of semiconductor light emitting elements 36 are surrounded by a frame body 37 formed of white resin. The LED chip 36a is connected to electrodes 38a and 38b via a gold bump 36c. The electrodes 38a and 38b are conductive members formed by patterning an aluminum nitride substrate 40.

The standard package 34 according to the embodiment is provided with four LED chips 36a, and the number of electrodes is five. The electrode between adjacent LED chips 36a is shared by the two LED chips 36a. For example, the LED chip 36a1 shown in Fig. 2C is connected one electrode 38a and the other electrode 38b. Further, the LED chip 36a2 shown in Fig. 2C is connected to one electrode 38a common to the other electrode 38b of the LED chip 36a1 and to the other electrode 38b common to one electrode 38a of the LED chip 36a3. Therefore, the number of electrodes of a standard package provided with n LED chips is n+1.

### (Light emitting module)

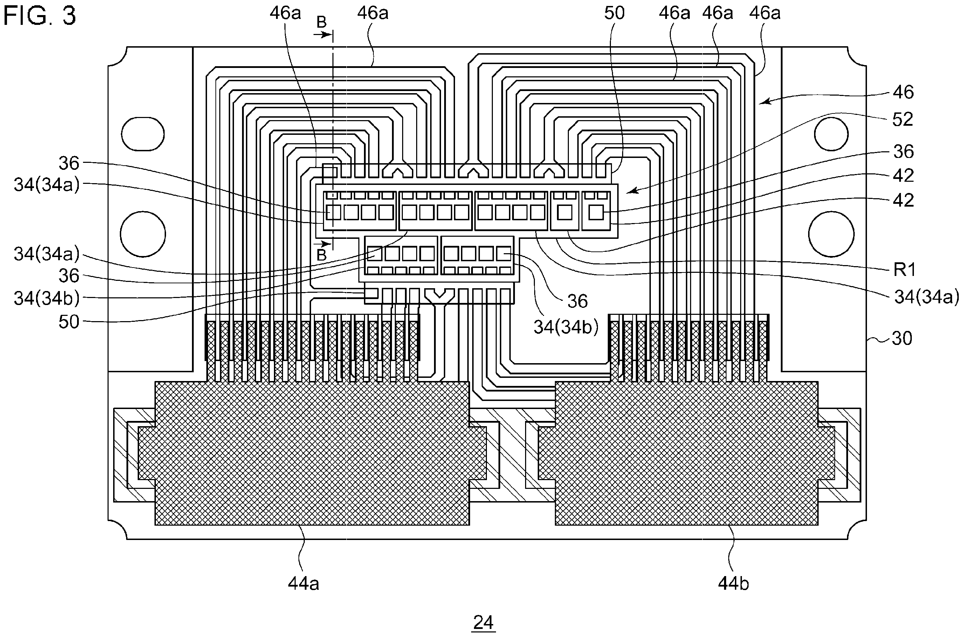

A description will now be given of the light emitting module in which the standard package described above is used. Fig. 3 is a front view of a light emitting module according to the embodiment.

As shown in Fig. 3, the light emitting module 24 includes a circuit substrate 30 including a copper wiring pattern, five standard packages 34, two standard packages 42, and two power feeding connectors 44a and 44b.

The semiconductor light emitting elements 36 function as sheet light sources that emit light and are arranged transversally such that the light emitting surfaces face a space in front of the vehicle. In this embodiment, three standard packages 34 (four LEDs each) and two standard packages 42 (one LED each) are horizontally arranged in a line in the first row toward the top of Fig. 3 so that a total of 14 semiconductor light emitting elements 36 are arranged in a line. In the second row toward the bottom of Fig. 3, two standard packages 34 (four LEDs each) are horizontally arranged in a line in the second row toward the bottom of Fig. 3 so that a total of eight semiconductor light emitting elements 36 are arranged in a line.

As shown in Fig. 3, the power feeding connectors 44a and 44b are connected to the respective semiconductor light emitting elements 36 by a power feeding circuit 46 formed on the circuit substrate 30. The power feeding circuit 46 is comprised of a plurality of wiring patterns 46a respectively corresponding to the semiconductor light emitting elements 36.

The connector units of wiring cords connected to a control circuit provided in the lamp chamber of the vehicle headlamp 10 are connected to the power feeding connectors 44a and 44b. Therefore, a power is supplied from the control circuit to the semiconductor light emitting elements 36 via the wiring cords, the power feeding connectors 44a and 44b, and the power feeding circuit 46. The control circuit controls each of the plurality of semiconductor light emitting elements 36 provided in the light emitting module 24 so as to turn it on or off.

The counter bore area R1 in the circuit substrate 30 shown in Fig. 3 for mounting of the first standard package 34a and the second standard package 34b is of substantially the same shape as that of the first standard package 34a and the second standard package 34b as arranged. In the area R1 of the circuit substrate 30, the bottom surface of the aluminum nitride substrate 40 is fixed to the surface of the area R1 via an adhesive (not shown).

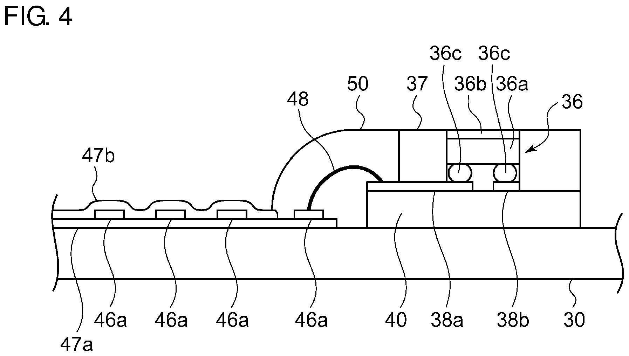

Fig. 4 is a B-B cross-sectional view of the light emitting module shown in Fig. 3. The wiring patterns 46a are formed on the circuit substrate 30 via an insulating layer 47a. The top of the wiring patterns 46a is also coated with an insulating layer 47b.

The electrode 38a is connected to an exposed portion of the wiring patterns 46a via a gold wire 48. The exposed portion of the wiring patterns 46a and the electrode 38a, along with the gold wire 48, are sealed by black resin 50. This inhibits the light emitted by the standard package 34 from being reflected or scattered by the black resin 50, thereby reducing glare.

As described above, the light emitting module 24 according to the embodiment is used in the lamp of the vehicle headlamp 10 such as the high beam lamp unit 20H. As shown in Fig. 3, the light emitting module 24 includes a light source comprised of the standard package 34 or the standard package 42 provided as light emitting element arrays, and a mount 52 for mounting of the standard packages. In the mount 52, a plurality of standard packages 34 of the same configuration are provided, and the standard package 34 has four light emitting elements carried thereon. In this way, at least a portion of the light emitting element array of a plurality of stages can be formed by the standard package 34 carrying a plurality of light emitting elements.

The standard package 34 includes the first standard package 34a forming the first row in the light emitting element array and the second standard package 34b forming the second row in the light emitting element array different from the first row. In this way, the standard packages 34 are used in a plurality of rows in the light emitting element array. The increase in the number of standard packages 34 employed enables reduction in the cost and improvement in the work efficiency.

As shown in Fig. 2, the standard package 34 includes the aluminum nitride substrate 40 (a ceramic substrate) as a rectangular sub-mount. A plurality of electrodes 38a are provided along one of longer sides 40a of the aluminum nitride substrate 40. The electrode 38a is used to feed power to the light emitting element. The one-sided arrangement of the electrodes 38a of the standard package 34 simplifies the layout of the wiring for feeding power as compared with the case where the electrodes 38a are on both sides.

The plurality of semiconductor light emitting elements 36 are provided between the other longer side 40b of the aluminum nitride substrate 40 and the plurality of electrodes 38a. As shown in Fig. 3, this makes it possible to reduce the distance between the plurality of semiconductor light emitting elements 36 mounted in the first standard package 34a and the semiconductor light emitting elements 36 mounted in the adjacent second standard package 34b.

Further, the mount 52 (area R1) shown in Fig. 3 is arranged such that the other longer side 40b of the plurality of first standard packages 34a and the other longer side 40b of the plurality of second standard packages 34b face each other. This increases the flexibility of the layout of the wiring pattern 46a for wiring the electrodes 38a and also simplifies the layout.

### (Further embodiment)

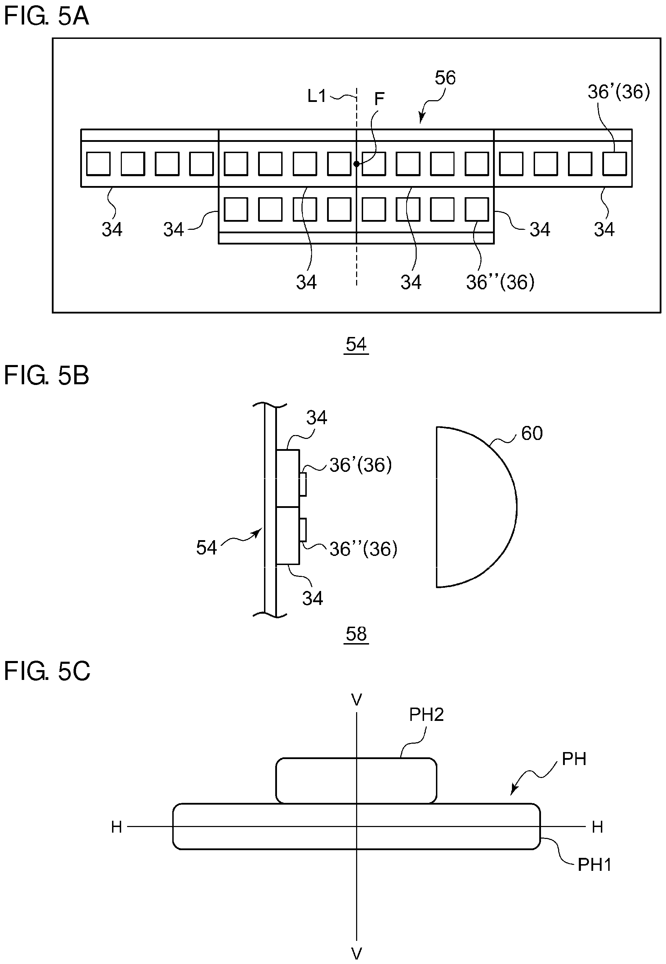

A description will now be given of a light distribution pattern of the lamp provided with the light emitting element array formed by combining standard packages. Fig. 5A is front view showing an exemplary light emitting module according to another embodiment; Fig. 5B is a side schematic view of the lamp unit provided with the light emitting module shown in Fig. 5A, and Fig. 5C shows a light distribution pattern formed by the lamp shown in Fig. 5B. A description or illustration of the details of the standard package 34 is omitted as appropriate.

In a mount 56 of a light emitting module 54 shown in Fig. 5A, a total of N1 (four) standard packages 34 provided with semiconductor light emitting elements 36' for radiating the lower part of the light distribution pattern and a total of N2 (two) standard packages 34 provided with semiconductor light emitting elements 36'' for radiating the upper part of the light distribution pattern are mounted.

A high beam lamp unit 58 shown in Fig. 5B includes the light emitting module 54 and the projection lens 60 as an optical member for projecting the light emitted by the light source of the light emitting module 54 forward as a light distribution pattern. The high beam lamp unit 58 is configured such that the vertical line L1 passing through the back focal point F of the projection lens 60 is located at the center of the mount 56. A total of 16 semiconductor light emitting elements 36' arranged in a line in the top row in the mount 56 constitute the lower light emitting part and form the partial high beam light distribution pattern PH1 shown in Fig. 5C. Further, a total of eight semiconductor light emitting elements 36'' arranged in a line in the bottom row in the mount 56 constitute the upper light emitting part and form the partial high beam light distribution pattern PH2 shown in Fig. 5C.

As a result, the high beam light distribution pattern PH in which the partial high beam light distribution pattern PH1 and the partial high beam light distribution pattern PH2 are combined is formed. The high beam light distribution pattern PH will radiate the horizontally symmetrical areas around the V-V line of the virtual screen. Further, the partial high beam light distribution pattern PH2 formed by the upper light distributing part has a narrower illuminated area than the partial high beam light distribution pattern PH1 formed by the lower light emitting part. In this way, the vertically asymmetrical high beam light distribution pattern PH is realized by using the standard packages.

We have conceived of a configuration whereby the desired light distribution characteristics are met and the illuminated range is extended at the same time, by shifting the positions of the first standard packages 34a or the second standard packages 34b from the positions shown in Fig. 5A. The right lamp and the left lamp are shifted in opposite directions.

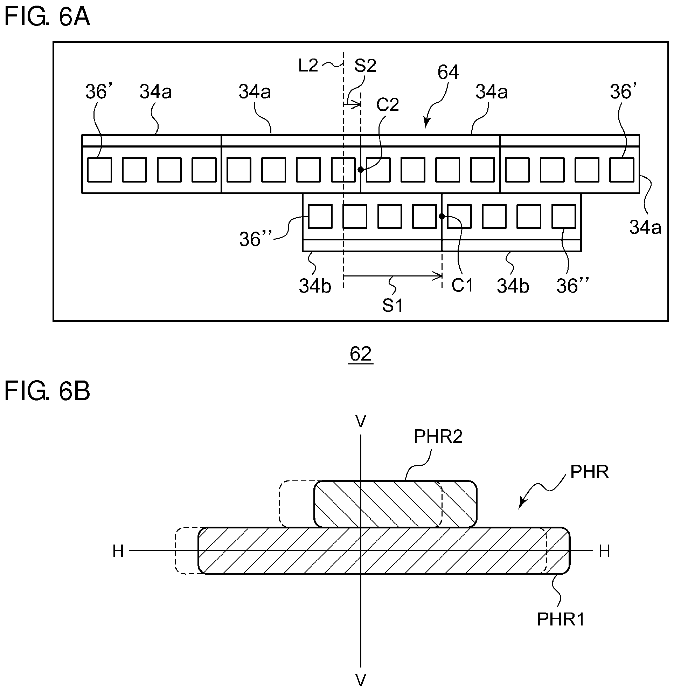

Fig. 6A is a front view showing a variation of the light emitting module applied to the right lamp according to the other embodiment, and Fig. 6B shows a light distribution pattern formed by the lamp provided with the light emitting module shown in Fig. 6A.

A light emitting module 62 of the right lamp according to the variation includes: a lower light emitting part formed by the first standard package 34a carrying the semiconductor light emitting elements 36' for radiating the lower part (PHR1) of the right high beam light distribution pattern PHR; and an upper light emitting part formed by the second standard package 34b carrying the semiconductor light emitting elements 36'' for radiating the upper part (PHR2) of the right high beam light distribution pattern PHR. Defining the position at which a straight line passing through the optical center (e.g., light axis) or the dimensional center (e.g., center of the lens width) of the optical member such as the projection lens intersects a mount 64 as a reference point (straight line L2), the first offset S1 by which the center C1 of the upper light emitting part is shifted from the straight line L2 in the direction of vehicle width is larger than the second offset S2 by which the center C2 of the lower light emitting part is shifted from the straight line L2 in the direction of vehicle width.

The right lamp configured in this way is capable of forming the right high beam light distribution pattern PHR offset rightward from the V-V line, as shown in Fig. 6B.

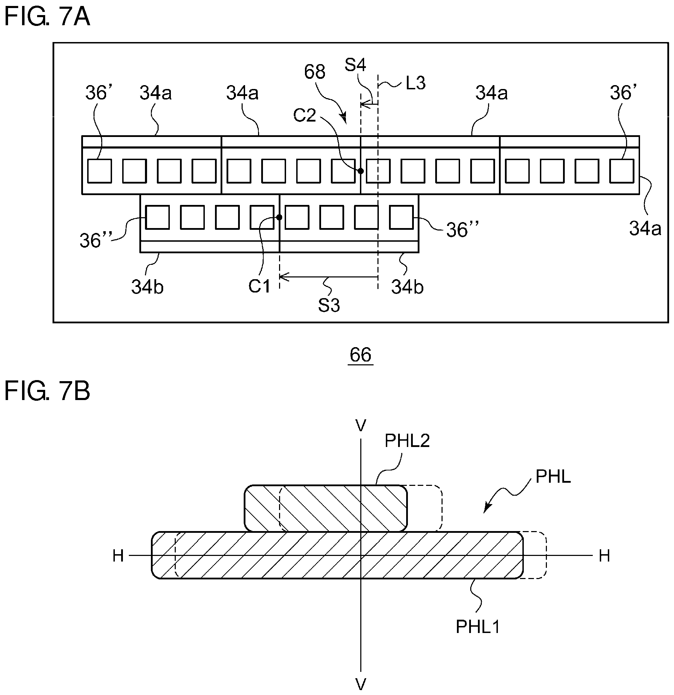

Fig. 7A is a front view showing a variation of the light emitting module applied to the left lamp according to the other embodiment, and Fig. 7B shows a light distribution pattern formed by the lamp provided with the light emitting module shown in Fig. 7A.

A light emitting module 66 of the left lamp according to the variation includes: a lower light emitting part formed by the first standard package 34a carrying the semiconductor light emitting elements 36' for radiating the lower part (PHL1) of the left high beam light distribution pattern PHL; and an upper light emitting part formed by the second standard package 34b carrying the semiconductor light emitting elements 36'' for radiating the upper part (PHL2) of the left high beam light distribution pattern PHL. Defining the position at which a straight line passing through the optical center (e.g., light axis) or the dimensional center (e.g., center of the lens width) of the optical member such as the projection lens intersects a mount 68 as a reference point (straight line L3), the first offset S3 by which the center C1 of the upper light emitting part is shifted from the straight line L3 in the direction of vehicle width is larger than the second offset S4 by which the center C2 of the lower light emitting part is shifted from the straight line L3 in the direction of vehicle width.

The left lamp configured in this way is capable of forming the left high beam light distribution pattern PHL offset leftward from the V-V line, as shown in Fig. 7B.

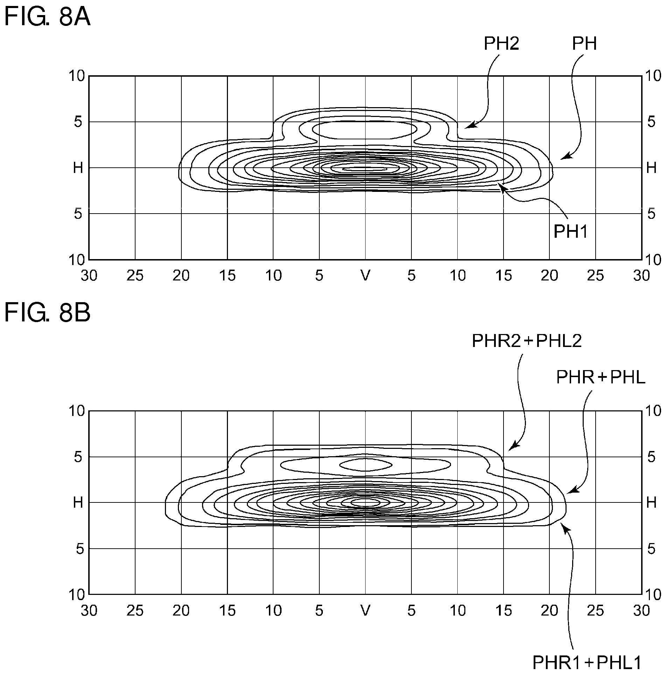

Fig. 8A shows illumination distribution occurring when the light emitting module shown in Fig. 5a is used in the right lamp and the left lamp, and Fig. 8B shows illumination distribution occurring when the the light emitting module shown in Fig. 6A is used in the right lamp and the light emitting module shown in Fig. 7A is used in the left lamp.

As shown in Fig. 8B, the horizontal illuminated area in the upper part (PHR2+PHL2) of the high beam light distribution pattern (PHR+PHL) is particularly extended by offsetting the standard package rightward in the right lamp and offsetting the standard package leftward in the left lamp. Extending the illuminated area results in lower brightness. However, the upper part of the high beam light distribution pattern does not require the brightness as much as the lower part. Therefore, extension of the illuminated area without increasing the number of standard packages is quite advantageous in terms of the cost.

Thus, in the vehicle headlamp in which a pair of left and right lamp units in a mirror arrangement are used, the illuminated range illuminated by the combined light distribution pattern, produced by the upper light emitting parts of the respective lamp units each formed by a relatively small number of standard packages, can be extended.

The light emitting module according to the embodiment can address the various number of light emitting elements and device intervals by combining standard packages. Mounting all light emitting elements in a single sub-mount created a wasted area in which light emitting elements are not mounted. According to the light emitting module of the embodiment, there is no such waste. Therefore, the benefit of cost reduction is remarkable in the case an expensive ceramic such as aluminum nitride is used for the sub-mount. Since it is possible to realize a light emitting element array having a large number of light emitting elements by combining a large number of standard packages, there is no need to employ a special sub-mount.

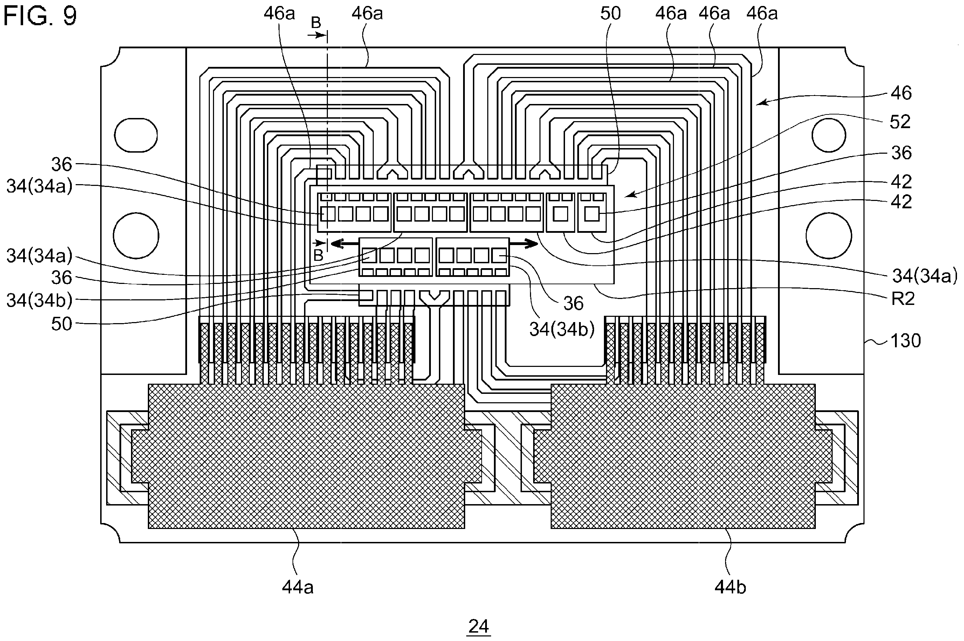

Fig. 9 is a front view of a light emitting module according to a variation of the embodiment. The counter bore area R2 in a circuit substrate 130 shown in Fig. 9 for mounting of the first standard package 34a and the second standard package 34b is larger than the shape of the first standard package 34a and the second standard package 34b as arranged. For this reason, the flexibility (e.g., in the transversal direction) in the position that the second standard package 34b is mounted is increased, and the versatility of the circuit substrate 130 is increased.

The arrangement also makes it possible to modify the light distribution pattern formed by the LED array to meet the specification for a refined light distribution pattern required in each vehicle type, by adjusting the positions of the first standard package 34a and the second standard package 34b. In this case, the distance from the exposed portion of a wiring pattern 46a near the area R1 to the electrodes 38a and 38b of the first standard package 34a and the second standard package 34b will differ depending on the specification. However, connections can be made by a gold wire 48 without any problem by modifying the program for controlling the gold wire. Consequently, the circuit substrate of the same copper wiring pattern can be used as a standard practice regardless of the specification so that the cost is reduced.

The embodiments of the present invention are not limited to those described above and appropriate combinations or replacements of the features of the embodiments are also encompassed by the present invention. The embodiments may be modified by way of combinations, rearranging of the processing sequence, design changes, etc., based on the knowledge of a skilled person, and such modifications are also within the scope of the present invention.

### [DESCRIPTION OF THE REFERENCE NUMERALS]

10 vehicle headlamp, 20H high beam lamp unit, 20L low beam lamp unit, 22 projection lens, 24 light emitting module, 26 LED array, 30 circuit substrate, 34 standard package, 34a first standard package, 34b second standard package, 36 semiconductor light emitting element, 36a LED chip, 36b fluorescent layer, 38a, 38b electrode, 40 aluminum nitride substrate, 40a, 40b longer side, 42 standard package, 52 mount

### [INDUSTRIAL APPLICABILITY]

The present invention relates to a lamp unit.

## Claims

1. A light emitting module used in a lamp, comprising:
a light source in which a plurality of light emitting elements are provided as a light emitting element array of a plurality of stages; and
a mount in which the light source is mounted, wherein
in the mount,
a plurality of standard packages of the same configuration are arranged, and
the standard package carries a plurality of light emitting elements.

2. The light emitting module according to claim 1, wherein
the standard package includes:
a first standard package that forms a first row in the light emitting element array, and
a second standard package that forms a second row in the light emitting element array different from the first row.

3. The light emitting module according to claim 1 or 2, wherein
the standard package includes a rectangular sub-mount, a plurality of electrodes being provided along one longer side of the sub-mount, and the electrodes being used to feed power to the light emitting elements.

4. The light emitting module according to claim 3, wherein
the plurality of light emitting elements are provided between the other longer side of the sub-mount and the plurality of electrodes.

5. The light emitting module according to claim 3 or 4, wherein
the plurality of standard packages are provided in the mount such that the electrodes are provided at an outer edge of the light emitting element array.

6. A lamp unit used in a vehicle headlamp, comprising:
the light emitting module according to any one of claims 1 through 5; and
an optical member that projects light emitted by the light source of the light emitting module forward as a light distribution pattern, wherein
the plurality of standard packages are provided in the mount such that the number N1 of standard packages carrying light emitting elements for radiating a lower part of the light distribution pattern is larger than the number N2 of standard packages carrying light emitting elements for radiating an upper part of the light distribution pattern.

7. The lamp unit according to claim 6, comprising:
a lower light emitting part formed by a standard package carrying the light emitting element for radiating a lower part of the light distribution pattern; and
an upper light emitting part formed by a standard package carrying the light emitting element for radiating an upper part of the light distribution pattern; and
defining a position at which a straight line passing through an optical center or a dimensional center of the optical member intersects the mount as a reference point, a first offset by which a center of the upper light emitting part is shifted from the reference point in a direction of vehicle width is larger than a second offset by which a center of the lower light emitting part is shifted from the reference point in a direction of vehicle width.
